# EUROPEAN PATENT APPLICATION

(11) **EP 3 604 729 A1**
(43) Date of publication of application: **05.02.2020**
(21) Application number: 17903443.4
(22) Date of filing: 26.12.2017
(51) Int. Cl.: E06B 9/386, E06B 5/00, E06B 9/264, H01L 31/054, H02S 40/22

(54) **TRANSPARENT SUBSTRATE AND BLIND**

(30) Priority: 31.03.2017 JP 2017071550
(71) Applicant: LIXIL Corporation, Koto-ku Tokyo 136-8535 (JP)
(72) Inventor: ISHII Hisashi, Tokyo 136-8535 (JP)
(74) Representative: Rössler, Matthias
(86) International application number: PCT/JP2017/046705
(87) International publication number: WO 2018/179648

(57) **Abstract**

A transparent base material 20 includes a transparent member 22, an infrared light reflecting layer 24 formed on one surface of the transparent member 22, and a solar cell layer 26 formed on the infrared light reflecting layer 24.

## Description

### [TECHNICAL FIELD]

The present invention relates to a transparent base material and a blind in which the transparent base material is used.

### [BACKGROUND ART]

There has been conventionally known a blind of which the slats each have a light reflecting surface on one side, and a light absorbing surface on the other side, so as to actively control indoor temperatures (see Patent Document 1, for example).

A blind configured as described above can effectively reflect solar rays in summertime by allowing the light reflecting surfaces formed on the slats to face the outdoor side, thereby effectively restraining a rise in indoor temperature. In wintertime, on the other hand, the blind effectively absorbs solar rays by allowing the light absorbing surfaces formed on the slats to face the outdoor side, thereby effectively promoting a rise in indoor temperature.

### [PRIOR ART REFERENCE]

### [PATENT DOCUMENT]

[Patent Document 1] Japanese Unexamined Patent Application Publication No. 2007-85082

### [DISCLOSURE OF INVENTION]

### [PROBLEM(S) TO BE SOLVED BY THE INVENTION]

However, there is a problem in that the blind as described above exhibits low light transmissivity when the slats are closed, so that the visibility from the indoor side becomes low.

The present invention has been made in view of such a problem, and a purpose thereof is to provide a transparent base material that can improve thermal insulation properties while ensuring light transmissivity, and a blind in which the transparent base material is used.

### [MEANS TO SOLVE THE PROBLEM(S)]

To solve the problem above, a transparent base material according to one embodiment of the present invention includes a transparent member, an infrared light reflecting layer formed on one surface of the transparent member, and a solar cell layer formed on the infrared light reflecting layer.

Another embodiment of the present invention also relates to a transparent base material. The transparent base material includes a transparent base material, a solar cell layer formed on one surface of the transparent member, and an infrared light reflecting layer formed on the other surface of the transparent member.

Yet another embodiment of the present invention relates to a blind including a slat for which the abovementioned transparent base material is used.

### [ADVANTAGEOUS EFFECTS OF INVENTION]

The present invention provides a transparent base material that can improve thermal insulation properties while ensuring light transmissivity, and a blind in which the transparent base material is used.

### [BRIEF DESCRIPTION OF DRAWINGS]

Embodiments will now be described, by way of example only, with reference to the accompanying drawings which are meant to be exemplary, not limiting, and wherein like elements are numbered alike in several Figures, in which:
FIG. 1 is a front view of a blind to which a transparent base material according to an embodiment of the present invention is applicable;
FIG. 2 is a schematic sectional view used to describe a configuration of the transparent base material according to the embodiment of the present invention;
FIGS. 3A and 3B are schematic sectional views used to describe a configuration of a transparent base material according to another embodiment of the present invention;
FIG. 4 is a schematic sectional view used to describe a configuration of a transparent base material according to yet another embodiment of the present invention;
FIGS. 5A and 5B are schematic sectional views used to describe an example of a blind in which the transparent base material according to an embodiment of the present invention is used for slats;
FIG. 6 is a schematic horizontal sectional view used to describe a state where the blind shown in FIGS. 5 is mounted on a building; and
FIGS. 7A, 7B and 7C are schematic side views used to describe a modification of the blind in which the transparent base material according to an embodiment of the present invention is used for slats.

### [MODE FOR CARRYING OUT THE INVENTION]

In the following, the present invention will be described based on preferred embodiments with reference to the drawings. Like reference characters denote like or corresponding constituting elements and members in each drawing, and repetitive description will be omitted as appropriate. Also, the dimensions of a member may be appropriately enlarged or reduced in each drawing in order to facilitate understanding. Further, in each drawing, part of a member less important in describing embodiments may be omitted.

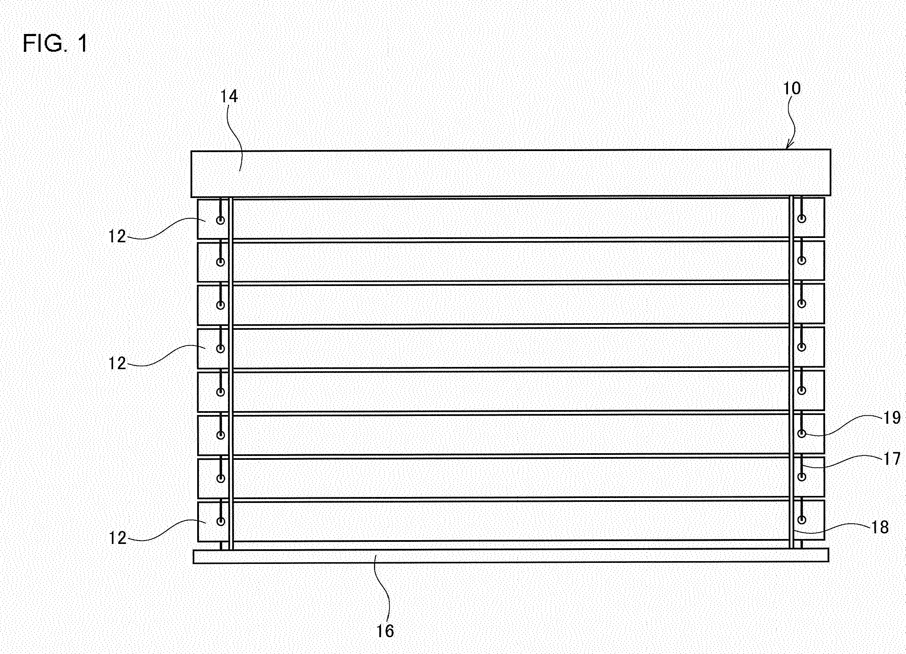

FIG. 1 is a front view of a blind 10 to which a transparent base material according to an embodiment of the present invention is applicable.

The blind 10 according to the present embodiment is configured by longitudinally arranging multiple (eight in this example) slats 12, which each are laterally long, to form a blind shape. Each slat 12 may be formed in a substantially rectangle shape that is laterally long, for example. The slats 12 are formed using a transparent base material, which will be described later.

The blind 10 further includes a headbox 14, a bottom rail 16, ladder cords 18, and lifting and lowering cords 17.

The headbox 14 is provided above the multiple slats 12 and constitutes the top part of the blind 10. The headbox 14 is fixed to a blind box or window frame (not illustrated). Within the headbox 14, an angle adjustment mechanism (not illustrated) and a lifting and lowering mechanism (not illustrated) for the slats 12 are provided.

The bottom rail 16 is provided below the multiple slats 12 and constitutes the bottom part of the blind 10.

The ladder cords 18 are cord members for adjusting the angle of the slats 12 in the blind 10. The ladder cords 18 are respectively connected to the both sides in a width direction of each slat 12. The upper end of each ladder cord 18 is connected to the angle adjustment mechanism (not illustrated) within the headbox 14.

The lifting and lowering cords 17 are cord members used to pull up the bottom rail 16 and thereby also pulling up and stacking the multiple slats 12, and to lower the bottom rail 16 and thereby also lowering and separating the multiple slats 12. The lower end of each lifting and lowering cord 17 is made to pass through a through hole 19 drilled in each slat 12 and is connected to the bottom rail 16. The upper end of each lifting and lowering cord 17 is connected to the lifting and lowering mechanism within the headbox 14.

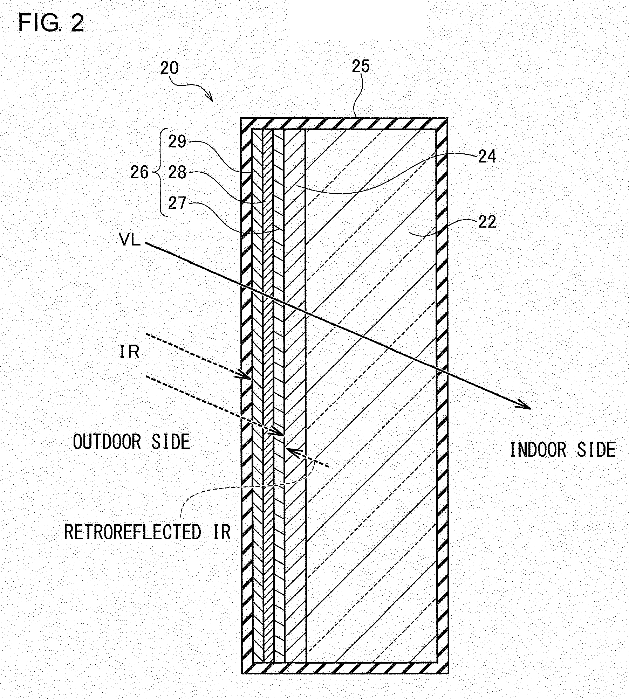

FIG. 2 is a schematic sectional view used to describe a configuration of a transparent base material 20 according to the embodiment of the present invention. In the present specification, "transparent" means being transparent for visible light, i.e. being capable of transmitting visible light. The transparent base material 20 according to the present embodiment is applicable to building components provided in opening parts in buildings, such as blinds and windows.

As shown in FIG. 2, the transparent base material 20 includes a transparent member 22, an infrared light reflecting layer 24 formed on one surface of the transparent member 22, a solar cell layer 26 formed on the infrared light reflecting layer 24, and an insulating layer 25 that covers the entirety of the transparent base material 20.

The transparent member 22 may be a plate-like body formed of transparent resin, such as polycarbonate, or glass, for example. The infrared light reflecting layer 24 is a reflecting layer formed such as to transmit visible light rays and reflect infrared light, and may be formed of a dielectric multilayer film, for example. In the present embodiment, the infrared light reflecting layer 24 is a reflecting layer with retroreflective properties for causing retroreflection of infrared light; however, the infrared light reflecting layer 24 may be a general reflecting layer without retroreflective properties.

In the present embodiment, the solar cell layer 26 is a bifacial solar cell and may be formed by laminating, on the infrared light reflecting layer 24, a first solar cell layer 27, a transparent conductive layer 28, and a second solar cell layer 29 in this order, for example. The solar cell may be a crystal cell, and may be a cell structured to have slits through which light passes. With regard to crystal cells, bifacial-type cells may be selected, and light in the infrared wavelength region can be converted into electricity by the photoelectric effect, so that the thermal load on the indoor side can be reduced. The solar cell may be an organic photovoltaic cell (OPV), a dye sensitized solar cell (DSSC), or the like. The insulating layer 25 may be an ethylene-tetrafluoroethylene copolymer (ETFE) film, for example.

The solar cell layer 26 is a solar cell with high sensitivity to light with a wavelength in the infrared region. In other words, the solar cell layer 26 is a solar cell with high photoelectric conversion efficiency for light with a wavelength in the infrared region.

When the transparent base material 20 according to the present embodiment is applied to the blind 10 as shown in FIG. 1, for example, the transparent base material 20 is disposed such that the side with the solar cell layer 26 formed thereon faces the outdoor side.

FIG. 2 schematically illustrates visible light VL and infrared light IR incident on the transparent base material 20. As shown in FIG. 2, the visible light VL penetrates the entire transparent base material 20 and is provided to the indoor side.

Meanwhile, part of the infrared light IR passes through the insulating layer 25 and is photoelectrically converted in the second solar cell layer 29. Also, another part of the infrared light IR passes through the insulating layer 25 and the solar cell layer 26 and is retroreflected by the infrared light reflecting layer 24. The infrared light IR thus retroreflected is then photoelectrically converted in the first solar cell layer 27. The electricity generated by the photoelectric conversion in the first solar cell layer 27 and the second solar cell layer 29 is extracted to the outside via the transparent conductive layer 28.

Thus, the transparent base material 20 according to the present embodiment can transmit the visible light VL to the indoor side. Meanwhile, since the infrared light IR is converted into electricity in the solar cell layer 26, heat caused by the infrared light IR is scarcely transmitted to the indoor side. Therefore, the transparent base material 20 according to the present embodiment is effective in summertime, for example, as the heat shielding properties and the solar heat gain coefficient can be reduced while light transmissivity is ensured.

Over general transparent base materials, the transparent base material 20 has the advantage of generating electricity. Further, in the transparent base material 20 according to the present embodiment, the infrared light reflecting layer 24 is disposed behind the solar cell layer 26 such that electricity can be generated on the both surfaces of the solar cell layer 26, thereby improving the efficiency of electricity generation.

Although the solar cell layer 26 is a bifacial solar cell layer in the present embodiment, the solar cell layer 26 may be a monofacial solar cell layer instead. In this case, the transparent base material 20 will be configured such that the transparent conductive layer 28 and the monofacial solar cell layer are laminated in this order on the infrared light reflecting layer 24.

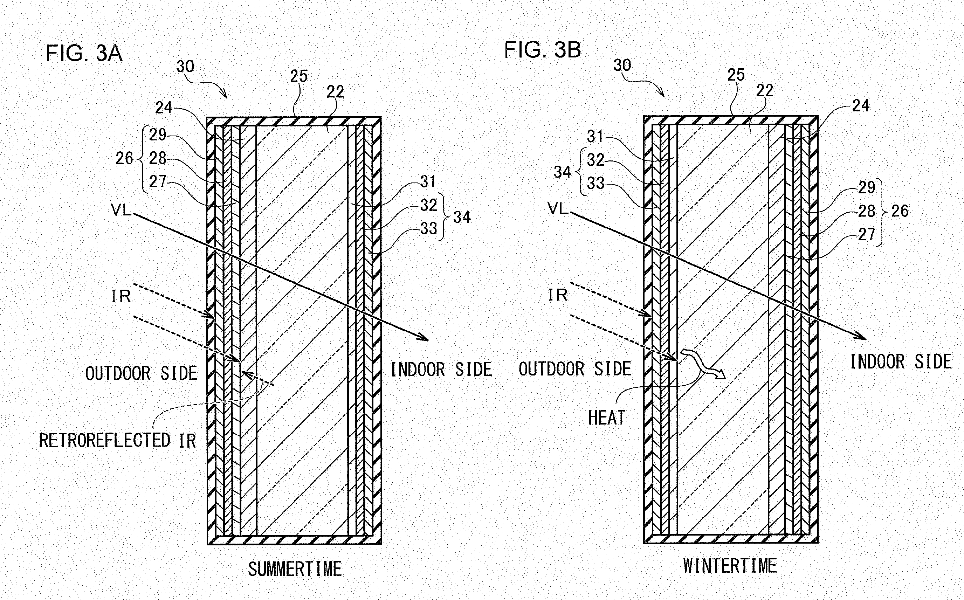

FIGS. 3A and 3B are schematic sectional views used to describe a configuration of a transparent base material 30 according to another embodiment of the present invention. The transparent base material 20 according to the present embodiment is also applicable to building components provided in opening parts in buildings, such as blinds and windows.

The transparent base material 30 according to the present embodiment is configured to obtain different effects in summertime and wintertime by rotating the transparent base material 30 by 180 degrees. FIG. 3A shows a usage state in summertime, and FIG. 3B shows a usage state in wintertime.

As with the transparent base material 20 described with reference to FIG. 2, the transparent base material 30 also includes the infrared light reflecting layer 24 and the solar cell layer 26 formed on one surface of the transparent member 22. The transparent base material 30 according to the present embodiment further includes an infrared light selective absorption layer 31 formed on the other surface of the transparent member 22, and an additional solar cell layer 34 formed on the infrared light selective absorption layer 31. It can also be said that the infrared light selective absorption layer 31 is formed between the transparent member 22 and the additional solar cell layer 34. The additional solar cell layer 34 is a monofacial solar cell layer in which a transparent conductive layer 32 and a solar cell layer 33 are laminated in this order on the infrared light selective absorption layer 31. Also in the transparent base material 30, the insulating layer 25 is formed to cover the entirety of the transparent base material 30.

In summertime, the transparent base material 30 is disposed and used such that the side with the solar cell layer 26 and the infrared light reflecting layer 24 formed thereon faces the outdoor side, as shown in FIG. 3A.

When the transparent base material 30 is thus disposed, similarly to the transparent base material 20 described with reference to FIG. 2, the visible light VL penetrates the entire transparent base material 20 and is provided to the indoor side, and the infrared light IR is converted into electricity in the solar cell layer 26. This prevents transmission of heat caused by the infrared light IR to the indoor side while ensuring light transmissivity. As a result, cooling efficiency in summertime can be improved.

In wintertime, on the other hand, the transparent base material 30 is disposed and used such that the side with the infrared light selective absorption layer 31 and the additional solar cell layer 34 formed thereon faces the outdoor side, as shown in FIG. 3B. When the transparent base material 30 is thus disposed, the visible light VL penetrates the entire transparent base material 20 and is provided to the indoor side.

Meanwhile, part of the infrared light IR passes through the insulating layer 25 and is photoelectrically converted in the additional solar cell layer 34. The generated electricity is extracted to the outside via the transparent conductive layer 32 {or a tab line (not illustrated) in the case of crystalline silicon}. Also, another part of the infrared light IR passes through the insulating layer 25 and the additional solar cell layer 34 and is absorbed in the infrared light selective absorption layer 31. The heat absorbed in the infrared light selective absorption layer 31 is transmitted through the transparent member 22. Since the heat thus transmitted through the transparent member 22 radiates outside, heat loss around the transparent base material 30 is reduced, thereby improving heating efficiency in wintertime.

When the transparent base material 30 configured as described above is used for the slats 12 of the blind 10 described with reference to FIG. 1, the usage state in summertime and the usage state in wintertime can be easily switched. The transparent base material 30 is also applicable to a pivot window that is rotatable about an axis.

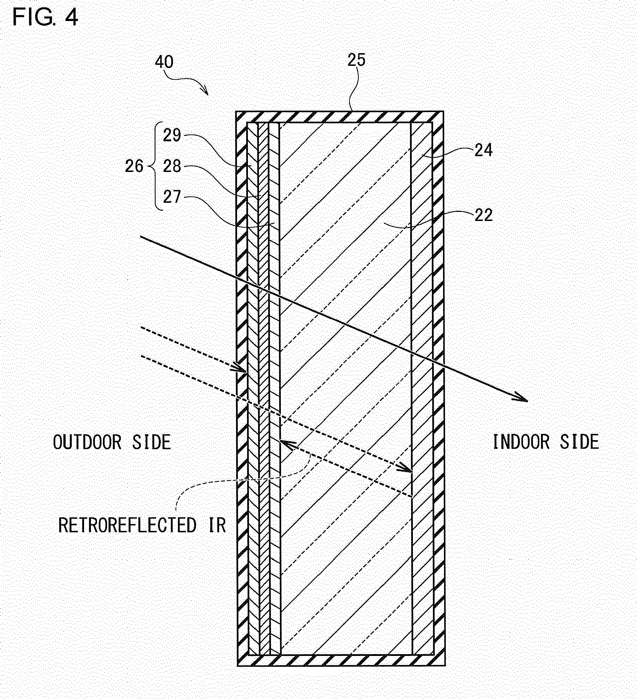

FIG. 4 is a schematic sectional view used to describe a configuration of a transparent base material 40 according to yet another embodiment of the present invention. The transparent base material 40 according to the present embodiment is also applicable to building components provided in opening parts in buildings, such as blinds and windows.

As shown in FIG. 4, the transparent base material 40 includes the transparent member 22, the solar cell layer 26 formed on one surface of the transparent member 22, the infrared light reflecting layer 24 formed on the other surface of the transparent member 22, and the insulating layer 25 that covers the entirety of the transparent base material 40. The solar cell layer 26 is a bifacial solar cell and formed by laminating, on the transparent member 22, the first solar cell layer 27, the transparent conductive layer 28, and the second solar cell layer 29 in this order. The transparent base material 40 according to the present embodiment is different from the transparent base material 20 shown in FIG. 1 in position where the infrared light reflecting layer 24 is formed.

When the transparent base material 40 according to the present embodiment is applied to the blind 10 as shown in FIG. 1, for example, the transparent base material 40 is disposed such that the side with the solar cell layer 26 formed thereon faces the outdoor side, and the side with the infrared light reflecting layer 24 formed thereon faces the indoor side.

In the present embodiment, the visible light VL penetrates the entire transparent base material 40 and is provided to the indoor side. Meanwhile, part of the infrared light IR passes through the insulating layer 25 and is photoelectrically converted in the second solar cell layer 29. Also, another part of the infrared light IR passes through the insulating layer 25, the solar cell layer 26, and the transparent member 22 and is retroreflected by the infrared light reflecting layer 24. The infrared light IR thus retroreflected then passes through the transparent member 22 and is photoelectrically converted in the first solar cell layer 27. The electricity generated by the photoelectric conversion in the first solar cell layer 27 and the second solar cell layer 29 is extracted to the outside via the transparent conductive layer 28.

Thus, the transparent base material 40 according to the present embodiment can also transmit the visible light VL to the indoor side. Meanwhile, since the infrared light IR is converted into electricity in the solar cell layer 26, compared to the conventional cases, a smaller amount of heat caused by the infrared light IR is transmitted to the indoor side. Thus, the transparent base material 40 according to the present embodiment can also improve the thermal insulation properties while ensuring the light transmissivity. As with the transparent base material 20 shown in FIG. 2, the transparent base material 40 can also improve the efficiency of electricity generation as the infrared light IR retroreflected by the infrared light reflecting layer 24 is received at the solar cell layer 26 of a bifacial type.

Although the solar cell layer 26 is a bifacial solar cell layer in the present embodiment, the solar cell layer 26 may be a monofacial solar cell layer instead. In this case, the transparent base material 40 will be configured such that the transparent conductive layer 28 and the monofacial solar cell layer are laminated in this order on the transparent member 22.

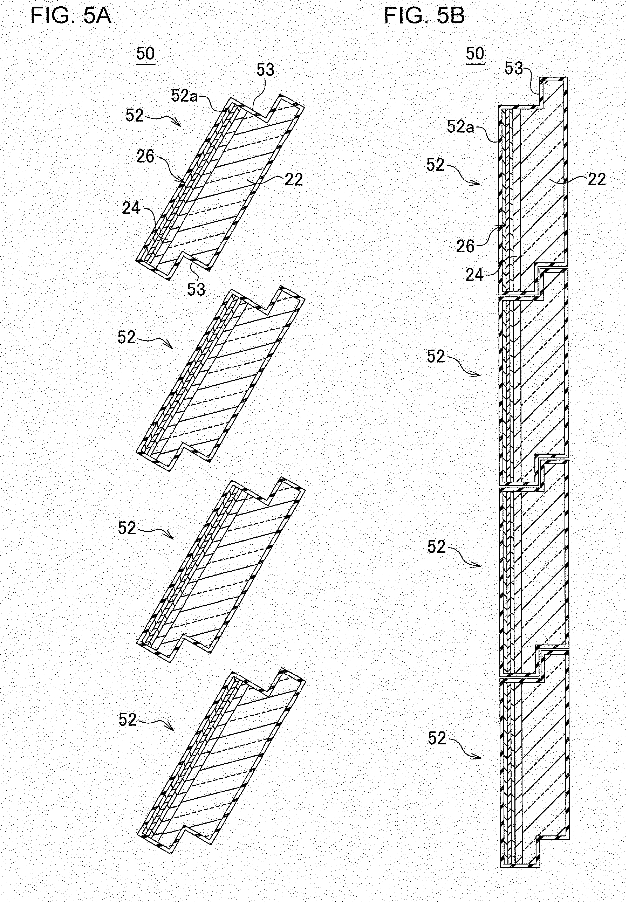

FIGS. 5A and 5B are schematic sectional views used to describe an example of a blind 50 in which the transparent base material according to an embodiment of the present invention is used for slats. FIGS. 5A and 5B each show a state where multiple (four in this example) slats 52 formed using the transparent base material 20 described with reference to FIG. 2 are longitudinally arranged. FIG. 5A shows a state where the slats 52 are open, and FIG. 5B shows a state where the slats 52 are closed.

At each of the top and the bottom of each slat 52, a step part 53 is formed. The step parts 53 are formed such that, when the slats 52 are closed, a step part 53 engages with another step part 53 of a neighboring slat 52, so that surfaces 52a on the solar cell layer 26 side of the slats 52 are flush with one another, as shown in FIG. 5B. When the blind 50 is mounted on an opening part in a building, the surfaces 52a of the slats 52 face the outdoor side.

Although the slats are formed using the transparent base material 20 shown in FIG. 2 in this example, the slats may also be formed using the transparent base material 30 shown in FIGS. 3 or the transparent base material 40 shown in FIG. 4, as a matter of course.

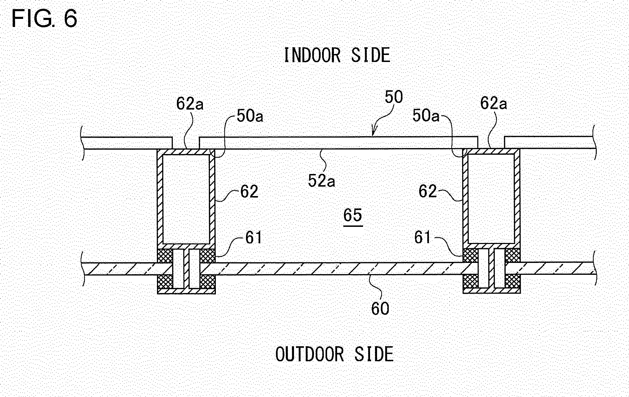

FIG. 6 is a schematic horizontal sectional view used to describe a state where the blind 50 shown in FIGS. 5 is mounted on a building. FIG. 6 shows curtain wall construction in which a glass panel 60 is mounted on mullions 62 using structural sealants 61.

In the curtain wall shown in FIG. 6, the blind 50 is disposed on the inside (the indoor side) of the glass panel 60. As is evident in FIG. 6, each end part in a lateral direction of the blind 50 abuts against an indoor-side surface 62a of a mullion 62. As described previously, the blind 50 is formed such that the surfaces 52a of the slats in the closed state are flush with one another. Accordingly, when the blind 50 is in the closed state, each end part 50a of the blind 50 can be set to abut against the indoor-side surface 62a of a mullion 62 with little space therebetween. At the time, if the glass panel 60 is viewed as an outer skin and the blind 50 is viewed as an inner skin, a condition closer to a curtain wall with a double skin structure can be made.

As shown in FIG. 6, between the glass panel 60 and the blind 50, an intermediate air layer 65 is formed. The intermediate air layer 65 functions as a heat insulating layer in wintertime, thereby improving the heating efficiency on the indoor side.

In the curtain wall construction shown in FIG. 6, a buffer material, such as rubber, may be provided on at least one of each end part 50a of the blind 50 and the indoor-side surface 62a of each mullion 62, so as to provide a structure in which a buffer material intervenes between the indoor-side surface 62a of each mullion 62 and each end part 50a of the blind 50 when the slats of the blind 50 are closed. This can prevent causing sound when the blind 50 is in contact with the mullions 62 and also prevent causing damage due to such contact between the blind 50 and the mullions 62.

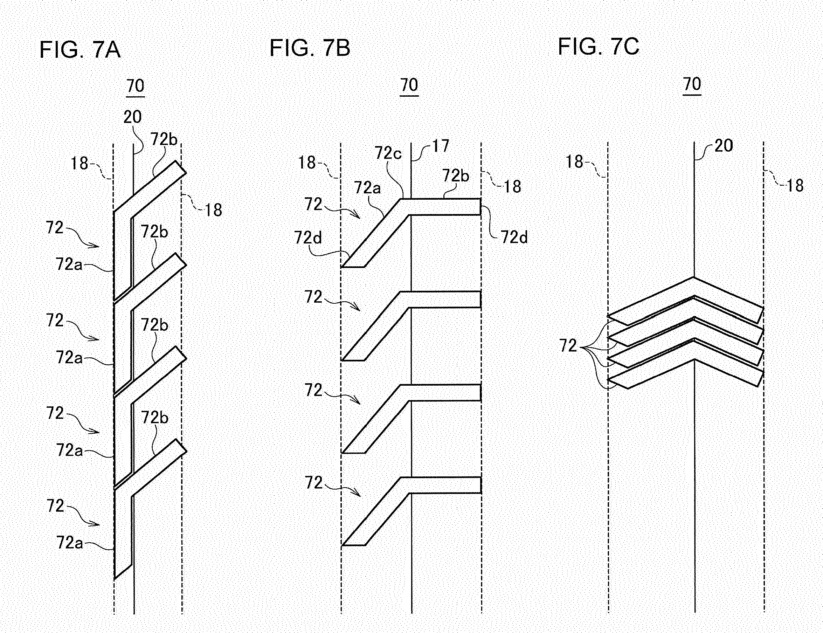

FIGS. 7A, 7B and 7C are schematic side views used to describe a modification with a blind 70 in which the transparent base material according to an embodiment of the present invention is used for slats. FIGS. 7A, 7B and 7C each show a state where multiple (four in this example) slats 72 are longitudinally arranged. FIG. 7A shows a state where the slats 72 are closed, FIG. 7B shows a state where the slats 72 are opened by 45 degrees, and FIG. 7C shows a state where the slats 72 are stacked.

In the present modification, each slat 72 has a substantially dogleg shape in side view. It may also be said that a first surface part 72a and a second surface part 72b of each slat 72 are connected with each other at a predetermined angle. A lifting and lowering cord 17 is connected to a bent portion 72c of each slat 72, and ladder cords 18 are respectively connected to both ends 72d of each slat 72.

The slats 72 according to the present modification may also be formed using the aforementioned transparent base material. In the blind 70 according to the present modification, when the slats 72 are closed, the surfaces of the first surface parts 72a of the slats 72 are flush with one another, as shown in FIG. 7A. Accordingly, also when the blind 70 according to the present modification is applied to a curtain wall as shown in FIG. 6, the blind 70 can be made to abut against the indoor-side surfaces of mullions, so that a condition closer to a curtain wall with a double skin structure can be made.

The present invention has been described with reference to the embodiments. The embodiments are intended to be illustrative only, and it will be obvious to those skilled in the art that various modifications and changes could be developed within the scope of claims of the present invention and that such modifications and changes also fall within the scope of claims of the present invention. Therefore, the description in the present specification and the drawings should be regarded as exemplary rather than limitative.

According to the description above, the following inventions can be found.

A transparent base material according to one embodiment of the present invention includes a transparent member, an infrared light reflecting layer formed on one surface of the transparent member, and a solar cell layer formed on the infrared light reflecting layer.

According to this embodiment, visible light can be transmitted to the indoor side. Meanwhile, since infrared light is converted into electricity in the solar cell layer, heat caused by the infrared light is scarcely transmitted to the indoor side. Accordingly, the transparent base material according to the present embodiment can improve thermal insulation properties while ensuring light transmissivity.

The infrared light reflecting layer may be an infrared light retroreflective layer. The solar cell layer may be a bifacial solar cell layer. When the solar cell layer is crystalline silicon, slits may be provided in a non-transparent solar cell to obtain transmissivity. An additional solar cell layer may be provided on the other surface of the transparent member. An infrared light selective absorption layer may be further provided between the transparent member and the additional solar cell layer.

Another embodiment of the present invention relates to a transparent base material. The transparent base material includes a transparent base material, a solar cell layer formed on one surface of the transparent member, and an infrared light reflecting layer formed on the other surface of the transparent member.

According to this embodiment, visible light can be transmitted to the indoor side. Meanwhile, since infrared light is converted into electricity in the solar cell layer, compared to the conventional cases, a smaller amount of heat caused by the infrared light is transmitted to the indoor side. Accordingly, the transparent base material according to the present embodiment can improve thermal insulation properties while ensuring light transmissivity.

The infrared light reflecting layer may be an infrared light retroreflective layer. The solar cell layer may be a bifacial solar cell layer.

Yet another embodiment of the present invention relates to a blind including a slat for which the abovementioned transparent base material is used. In the blind according to this embodiment, a slat is formed using the abovementioned transparent base material, thereby improving thermal insulation properties while ensuring light transmissivity. The blind may be a vertical blind, or may be a horizontal blind.

### [EXPLANATION OF REFERENCE NUMERALS]

- 10, 50, 70: blind
- 12, 52, 72: slat
- 14: headbox
- 16: bottom rail
- 18: ladder cord
- 20, 30, 40: transparent base material
- 22: transparent member
- 24: infrared light reflecting layer
- 25: insulating layer
- 26, 34: solar cell layer
- 27: first solar cell layer
- 28: transparent conductive layer
- 29: second solar cell layer
- 31: infrared light selective absorption layer
- 32: transparent conductive layer
- 53: step part
- 60: glass panel
- 62: mullion
- 65: intermediate air layer

### [INDUSTRIAL APPLICABILITY]

The present invention is applicable to building components provided in opening parts in buildings, such as blinds and windows.

## Claims

1. A transparent base material, comprising:
a transparent member;
an infrared light reflecting layer formed on one surface of the transparent member; and
a solar cell layer formed on the infrared light reflecting layer.

2. The transparent base material according to claim 1, wherein the infrared light reflecting layer is an infrared light retroreflective layer.

3. The transparent base material according to claim 1 or 2, wherein the solar cell layer is a bifacial solar cell layer.

4. The transparent base material according to any one of claims 1 through 3, wherein an additional solar cell layer is provided on the other surface of the transparent member.

5. The transparent base material according to claim 4, further comprising an infrared light selective absorption layer between the transparent member and the additional solar cell layer.

6. A transparent base material, comprising:
a transparent member;
a solar cell layer formed on one surface of the transparent member; and
an infrared light reflecting layer formed on the other surface of the transparent member.

7. The transparent base material according to claim 6, wherein the infrared light reflecting layer is an infrared light retroreflective layer.

8. The transparent base material according to claim 6 or 7, wherein the solar cell layer is a bifacial solar cell layer.

9. A blind comprising a slat for which the transparent base material according to any one of claims 1 through 8 is used.
